# EUROPEAN PATENT SPECIFICATION

(11) **EP 0 849 240 B1**
(45) Date of publication and mention of the grant of the patent: **11.08.1999**
(21) Application number: 97310047.2
(22) Date of filing: 12.12.1997
(51) Int. Cl.: C04B 41/50, C04B 41/45

(54) **Method of producing low dielectric ceramic-like materials**
Verfahren zur Herstellung von keramischen Materialien mit niedriger Dielektrizitätskonstante
Procédé de fabrication de matériau céramique ayant une permittivité basse

(30) Priority: 20.12.1996 US 771627
(43) Date of publication of application: 24.06.1998
(73) Proprietor: DOW CORNING CORPORATION, Midland Michigan 48686-0994 (US)
(72) Inventor: Bremmer, Jeffrey Nicholas, Midland, Michigan 48640 (US); Liu, Youfan, Midland, Michigan 48640 (US)
(74) Representative: Hall, Marina

(56) References cited:
- EP-A- 0 606 580
- US-A- 5 320 868
- US-A- 5 541 248
- , GMELINS HANDBUCH DER ANORGANISCHEN CHEMIE, BAND 4 XP002060073 * page 78 *

## Description

This invention pertains to a method of forming ceramic-like coatings by applying to a substrate a hydrogen silsesquioxane resin and thereafter curing the hydrogen silsesquioxane resin in an inert atmosphere containing less than 100 ppm O₂ at a temperature of 375°C. or greater for a time sufficient to convert the hydrogen silsesquioxane resin into a ceramic-like coating. Preferably, the substrate is an electronic substrate.

The use of hydrogen silsesquioxane resin to produce ceramic coatings on electronic devices is known in the art. It is further known in the art to cure the hydrogen silsesquioxane resin in a variety of atmospheres to produce the ceramic coating. For example, U.S. Patent No. 4,756,977 describes a method for producing ceramic coatings by curing hydrogen silsesquioxane resin in an air environment. U.S. Patent No. 5,380,567 discloses a method for producing ceramic coatings by curing hydrogen silsesquioxane resin in an inert atmosphere such as argon or helium at temperatures of 500 to 1000°C. U.S. Patent No. 5,370,904 discloses a method for producing ceramic coatings by curing hydrogen silsesquioxane resin in an inert gas at a temperature of 250 to 500°C. until the content of the Si-bonded H in the silicon oxide product has reached ≤80% of the Si-bonded H in the starting hydrogen silsesquioxane. U.S. Patent 5,370,903 discloses a method for producing ceramic coatings by curing hydrogen silsesquioxane resin in an atmosphere containing > 0% up to 20 vol% oxygen and 80 to <100 vol% nitrogen at temperature of 250°C to <500°C until the content of the Si-bonded H in the silicon oxide product has reached ≤80% of the Si-bonded H in the starting hydrogen silsesquioxane.

EP-A-0,606,580 relates to a method for the formation of a thick silicon oxide film on the surface of a substrate. The method involves the formation of a hydrogen silsesquioxane resin film on the surface of a substrate and subsequent conversion of the hydrogen silsesquioxane resin into a silicon oxide ceramic by heating of the resin film-bearing substrate in a mixed gas atmosphere of 0 vol% to 20 vol% oxygen, but not including 0 vol%, and 80 vol%-to 100 vol% inert gas, but not including 100 vol%, until the content of silicon-bonded hydrogen in the silicon oxide product has reached ≤80% of the content of the silicon-bonded hydrogen in the hydrogen silsesquioxane resin. Examples of the inert gas which can be used in the method of EP-A-0,606,580 include nitrogen, argon, helium and neon. Nitrogen is preferred.

US patent no. 5,320,868 discloses a method for forming silicon oxide containing coatings on electronic substrates. Hydrogen silsesquioxane resin is converted into a silicon oxide containing ceramic coating in the presence of hydrogen gas. Almost any concentration of hydrogen gas is practical according to US patent no. 5,320,868 and the concentration range given is between about 0.01 and 100 vol%. The dilutant gas for the hydrogen can be any inert gas such as nitrogen, argon, helium or reactive gasses such as air, oxygen, oxygen plasma, ozone, ammonia, amines, moisture, nitrogen oxide.

US patent no. 5,541,248 relates to a luminescent coating which is formed by a coating composition comprising hydrogen silsesquioxane resin and phosphor filler diluted in a solvent. The method of US patent no. 5,541,248 involves first applying the composition of the invention on to the substrate. The coating on the substrate is then heated at a temperature sufficient to convert the composition to a luminescent ceramic coating. The heating step may be conducted at an effective atmospheric pressure from vacuum to superatmospheric under any effective oxidising or non-oxidising gasious environment such as those comprising air, oxygen, an insert gas such as nitrogen, ammonia, amines, moisture, nitrogen oxide and hydrogen.

Gmelins Handbuch der Anorganischen Chemie, vol 4, page 78, provides a technical definition of nitrogen and states that purest technical nitrogen has an approximate oxygen content of 0.10%, ie 1000 ppm.

None of these patents teach that the concentration of oxygen must be less than 100 ppm in order to produce coatings having a lower dielectric constant when heated at temperatures of 375°C or more.

Several methods for producing low dielectric constants in the ceramic coatings are also known in the art. For example, US Patent No. 5,523,163 discloses a method for producing Si-O containing ceramics having a dielectric constant less than or equal to 3.2. This method requires the annealing of a cured coating in an atmosphere containing hydrogen. US Patent No. 5,547,703 discloses a method for producing ceramic coatings having a low dielectric constant by heating the hydrogen silsesquioxane in an atmosphere containing ammonia and moisture and then in an atmosphere containing substantially anhydrous ammonia at a temperature sufficient to convert the hydrogen silsesquioxane resin to a Si-O containing ceramic coating. The Si-O containing ceramic coating is then exposed to an atmosphere containing oxygen for a time and at a temperature sufficient to anneal the coating.

We have found that when hydrogen silsesquioxane resin is heated in an inert atmosphere containing less than 100 ppm of oxygen at a temperature of 375°C or greater that the dielectric constant of the coating is reduced.

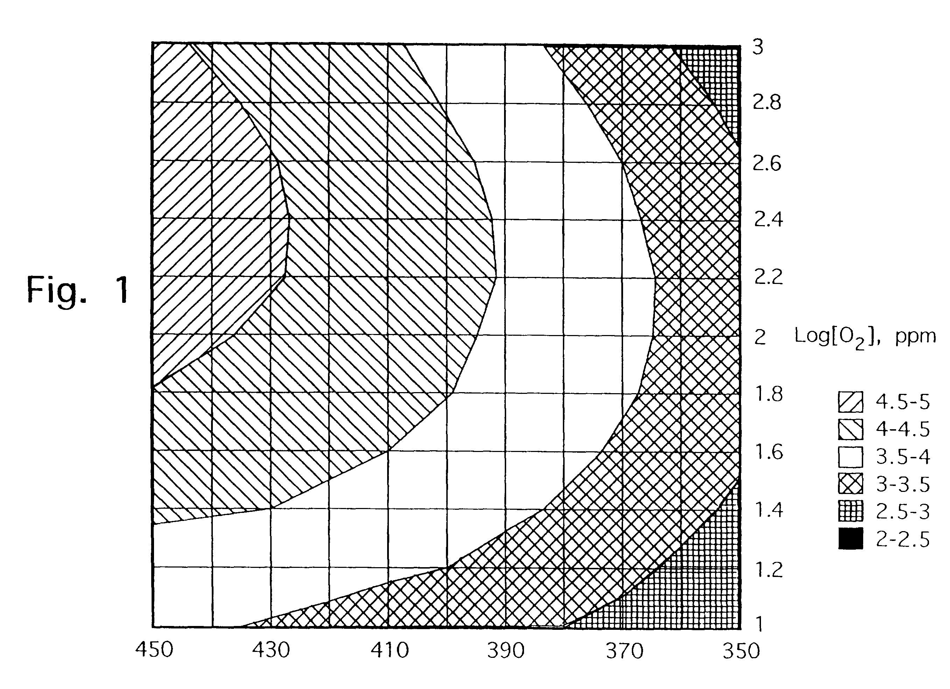

FIG. 1 represents a computer generated plot of dielectric constant as a function of temperature vs. log of oxygen content.

The instant invention pertains to a method of producing a ceramic-like coating on a substrate wherein the method comprises applying to the substrate a composition comprising a hydrogen silsesquioxane resin and thereafter heating the hydrogen silsesquioxane resin in an inert atmosphere containing less than 100 ppm of oxygen at a temperature of 375°C. or greater for a period of time sufficient to convert the hydrogen silsesquioxane resin into a ceramic-like coating. By "ceramic-like", it is meant to include silicon based materials wherein a substantial quantity of the Si atoms (e.g. ≥ about 50%) are bonded to 1 or 2 hydrogen atoms and may contain amorphous silica (SiO₂), amorphous silica-like materials that are not fully free of residual carbon, silanol (SiOH) and/or additional ceramic materials.

The hydrogen silsesquioxane resin which may be used in this invention includes hydridosiloxane resins containing units of the formula HSi(OH)ₓ(OR)_{y}O_{z/2}, in which each R is independently an organic group or a substituted organic group which, when bonded to silicon through the oxygen atom, forms a hydrolyzable substituent, x = 0-2, y = 0-2, z = 1-3, x + y + z = 3. Examples of R include alkyls such as methyl, ethyl, propyl, butyl, aryls such as phenyl, and alkenyls such as allyl or vinyl. These resins may be fully condensed (HSiO_{3/2})ₙ wherein n is an integer having a value of at least 8; or they may be only partially hydrolyzed (i.e., containing some Si-OR) and/or partially condensed (i.e., containing some Si-OH). Although not represented by this structure, these resins may also contain a small number (e.g., less than about 10%) of silicon atoms which have either 0 or 2 hydrogen atoms attached thereto or a small number of SiC bonds due to various factors involved in their formation or handling.

The above H-resins and methods for their production are known in the art. U.S. Patent No. 3,615,272 teaches the production of a nearly fully condensed H-resin (which may contain up to 100-300 ppm silanol) by a process comprising hydrolyzing trichlorosilane in a benzenesulfonic acid hydrate hydrolysis medium and then washing the resultant resin with water or aqueous sulfuric acid. Similarly, US Patent No. 5,010,159 teaches an alternative method comprising hydrolyzing hydridosilanes in an arylsulfonic acid hydrate hydrolysis medium to form a resin which is then contacted with a neutralizing agent.

Other hydridosiloxane resins, such as those described in US Patent No. 4,999,397, those produced by hydrolyzing an alkoxy or acyloxy silane in an acidic, alcoholic hydrolysis medium, those described in Kokai Patent Nos. 59-178749, 60-86017 and 63-107122 or any other equivalent hydridosiloxane, will also function herein.

It is to be noted that in a preferred embodiment of the invention, specific molecular weight fractions of the above H-resins may also be used in this process. Such fractions and methods for their preparation are taught by U.S. Patents 5,063,267 and 5,416,190. A preferred fraction comprises material wherein at least 75% of the polymeric species have a molecular weight above about 1200 and a more preferred fraction comprises material wherein at least 75% of the polymeric species have a number average molecular weight of from 1200 to 100,000.

The hydrogen silsesquioxane resin may contain a platinum, rhodium or copper catalyst. Generally, any platinum, rhodium or copper compound or complex which can be solubilized will be functional. For instance, platinum acetylacetonate, rhodium catalyst RhCl₃ [S(CH₂CH₂CH₂CH₃)₂]₃, obtained from Dow Corning Corporation, Midland, Mich., or cupric naphthenate are all within the scope of this invention. These catalysts are generally added in an amount of 5 to 1000 ppm platinum, rhodium or copper based on the weight of hydrogen silsesquioxane resin.

The hydrogen silsesquioxane resin alternatively, may also contain an organic or inorganic peroxide. Organic and inorganic peroxides useful in the instant invention may be exemplified by barium peroxide, strontium peroxide, calcium peroxide, α,α-bis-tertiary peroxydiisopropylbenzene, dicumyl peroxide and benzoyl peroxide.

Other ceramic oxide precursors may also be used in combination with the above hydrogen silsesquioxane resin. The ceramic oxide precursors specifically contemplated herein include compounds of various metals such as aluminum, titanium, zirconium, tantalum, niobium and/or vanadium as well as various non-metallic compounds such as those of boron or phosphorous which may be dissolved in solution, hydrolyzed, and subsequently pyrolyzed at relatively low temperatures to form ceramic oxides. The use of the ceramic oxide precursors is described in U.S. Patent Nos. 4,753,855 and 4,973,526.

The above ceramic oxide precursors generally have one or more hydrolyzable groups bonded to the above metal or non-metal, depending on the valence of the metal. The number of hydrolyzable groups to be included in these compounds is not critical as long as the compound is soluble or can be dispersed in the solvent. Likewise, selection of the exact hydrolyzable substituent is not critical since the substituents are either hydrolyzed or pyrolyzed out of the system. Typical hydrolyzable groups include alkoxy, such as methoxy, propoxy, butoxy and hexoxy, acyloxy, such as acetoxy, other organic groups bonded to said metal or non-metal through an oxygen such as acetylacetonate or amino groups. Specific compounds, therefore, include zirconium tetracetylacetonate, titanium dibutoxy diacetylacetonate, aluminum triacetylacetonate, tetraisobutoxy titanium and Ti(N(CH₃)₂)₄.

When a ceramic oxide precursor is combined with the hydrogen silsesquioxane resin, generally it is used in an amount such that the coating composition contains 0.1 to 30 percent by weight ceramic oxide precursor based on the weight of the hydrogen silsesquioxane resin.

If desired, other materials may also be present in the coating composition. For example, adhesion promoters, suspending agents and other optional components may be added. The adhesion promoters may be exemplified by silanes such as glycidoxypropyltrimethoxysilane, mercaptopropyltrimethoxysilane and vinyl triacetoxysilane.

The hydrogen silsesquioxane resin may be applied to the substrate in any manner, but a preferred method involves producing a solvent dispersion of the hydrogen silsesquioxane resin and any optional components and applying the solvent dispersion to the surface of the substrate. Various facilitating means such as stirring and/or heating may be used to dissolve or disperse the hydrogen silsesquioxane resin and create a more uniform application material.

The hydrogen silsesquioxane resin may be applied to any substrate such as metals or ceramics however, it is preferred to apply the hydrogen silsesquioxane resin to an electronic substrate. By "electronic substrate", it is meant to include silicon based devices and gallium arsenide based devices intended for use in the manufacture of a semiconductor component including focal plane arrays, optoelectronic devices, photovoltaic cells, optical devices, transistor-like devices, 3-D devices, silicon-on-insulator devices and super lattice devices. To further exemplify, electronic substrates include wafers resulting from the fabrication of integrated circuits and semiconductor devices. Typically the devices are completely fabricated up to the point of the interconnect system, usually bond pads, while still in the wafer stage. It is desirable and economical to apply these coatings to the electronic devices while they are still in the wafer stage as an electronic substrate. Such coated devices are then separated from each other and continued into the packaging and assembly stages. Alternately, the electronic substrates can be the actual separated semiconductor devices or integrated circuit devices, before or after the interconnects are made to an electronic assembly.

Solvents which may be used include any agent or mixture of agents which will dissolve the hydrogen silsesquioxane resin to form a homogeneous liquid mixture without affecting the resulting coating. These solvents can include alcohols such as ethyl alcohol or isopropyl alcohol; aromatic hydrocarbons such as benzene or toluene; alkanes such as n-heptane, dodecane or nonane; ketones; esters; glycol ethers or dimethylpolysiloxanes. The solvent is present in an amount sufficient to dissolve the hydrogen silsesquioxane resin to the concentration desired for application. Typically the solvent is present in an amount of 20 to 99.9 wt%, preferably from 50 to 99 wt%.

Specific methods for application of the solvent dispersion include spin coating, dip coating, spray coating, flow coating and screen printing. The solvent is then allowed to evaporate from the coated substrate resulting in the deposition of the hydrogen silsesquioxane resin. Any suitable means for evaporation may be used such as simple air drying by exposure to an ambient environment , by the application of a vacuum, or mild heat (≤50°C) or during the early stages of the curing process. It should be noted that when spin coating is used, the additional drying method is minimized as the spinning drives off the solvent.

Following removal of any solvent, a preceramic coating is formed on the substrate. The preceramic coating may be subjected to an intermediate heating in an inert atmosphere to melt and flow the hydrogen silsesquioxane resin prior to the heating to convert to a ceramic-like coating. Typically this intermediate heating is carried out at a temperature of from 150 to 400°C. and for very short periods of time. The preceramic coating is converted to a ceramic-like coating by exposing the hydrogen silsesquioxane resin to heat. The heating takes place in an inert atmosphere containing less than 100 parts per million (ppm) of oxygen, preferably less than 60 ppm oxygen. It is most preferred to cure the hydrogen silsesquioxane resin in an atmosphere containing no more than 10 ppm oxygen. Inert atmospheres useful herein include, but are not limited to, nitrogen, helium and argon, preferably nitrogen.

Generally, the temperature used to convert the preceramic coating is in the range of 375 to 1000°C. Preferred temperatures are in the range of 400 to 450°C. At temperatures below 375°C., the amount of oxygen in the inert atmosphere has little impact on the dielectric constant of the ceramic-like coating. Heating is generally conducted for a time sufficient to ceramify, generally up to 6 hours with less than 3 hours being preferred. Any method of heating such as the use of a convection oven, rapid thermal processing, hot plate, or radiant of microwave energy may be used herein. The rate of heating is also not critical but is most practical and preferred to heat as rapidly as possible.

By the above methods, a thin (less than 2 microns) ceramic-like coating is produced on the substrate having a lower dielectric constant. The coating smoothes the irregular surfaces of the various substrates and has excellent adhesion properties.

Additional coatings may be applied over the ceramic-like coating if desired. These can include, for example SiO₂ coatings, SiO₂/ceramic oxide layers, silicon containing coatings, silicon carbon containing coatings, silicon nitrogen containing coatings, silicon oxygen nitrogen containing coatings, silicon nitrogen carbon containing coatings and/or diamond like coatings produced from deposition (i.e. CVD, PECVD) of amorphous SiC:H, diamond, silicon nitride. Methods for the application of such coatings are known in the art and are described in U.S. Patent No. 4,756,977 and U.S. Patent No. 5,011,706.

The method of applying an additional coating such as silicon carbide is not critical, and such coatings can be applied by any chemical vapor deposition technique such as thermal chemical vapor deposition (TCVD), photochemical vapor deposition, plasma enhanced chemical vapor deposition (PECVD), electron cyclotron resonance (ECR), and jet vapor deposition. It could also be applied by physical vapor deposition techniques such as sputtering or electron beam evaporation. These processes involve either the addition of energy in the form of heat or plasma to a vaporized species to cause the desired reaction or they focus energy on a solid sample of the material to cause its deposition.

So that those skilled in the art can understand and appreciate the invention taught herein, the following examples are presented.

Soak Temperature and Soak Time represent the temperature the furnace was heated to for curing and the amount of time that it was held at this temperature during the cure.

Thickness After Cure was determined by using a using a NanoSpec/AFT Model 2100 Automated Film Thickness Instrument. Thickness was determined by a method of reflection spectroscopy whereby visible light is reflected from the surface of the measurement sample into a specially designed microscope. Film thickness is determined from the measured interferogram of reflection intensity as a function of wavelength with the use of a curve fitting algorithm provided by the vendor.

Dielectric Constant of the converted coating was determined by performing dielectric constant measurements on metal-insulator-semiconductor (MIS) capacitors. MIS capacitors were formed by depositing aluminum electrodes of approximately 0.15 µm unto low resistivity (*ρ* < 0.01Ω cm) silicon wafers coated with a thin film of the ceramic-like coating. A shadow mask was utilized to form aluminum electrode dots of diameter ranging from 3 to 10 mm. Impedance measurements were made across electrode dots of same diameter over frequency range of 0.1 - 1000 kHz using a Hewlett-Packard 4194A Impedance Analyzer. The impedance data was fit to a series RLC model from which the equivalent parallel capacitance and dielectric constant were calculated. Since capacitance was characterized across the surface dot electrodes, twice the dielectric thickness was used for dielectric constant measurements.

Normalized SiH bond density after cure was determined by FTIR. This FTIR method comprised using a Nicolet 5SXB Fourier Transform Infrared Spectrometer. A transmission sampling mode of operation was utilized. Prior to the spin coating of the wafer with the coating composition, a background spectra was collected on bare silicon wafers. The background was subtracted from a wafer having the ceramic-like film thereon to obtain spectra of the ceramic-like film only. A peak at wavenumber 2260 cm⁻¹ is indicative of the SiH bond density in the converted film. A ratio of this peak area per film thickness to an as spun film peak area per thickness was quantified to determine the normalized SiH bond density.

Oxygen present during the cure was measure by using a Toray LC800 Oxygen Analyzer manufactured by Toray Engineering Co., Ltd. The analyzer, with a measurement range of 0.1 ppm to 100% oxygen concentration, was connected to the exhaust line of the furnace.

### Example 1

A Box-Benken designed experiment was performed with variable cure process parameters of soak temperature, soak time and oxygen concentration in a quartz tube furnace. The soak temperature was varied in the ranges of 350 to 450°C., the soak time was varied from 0.5 to 1.5 hour and the oxygen concentration was varied from 10 ppm to 1000 ppm.

Sample wafers were coated with a coating composition comprising 22 wt% hydrogen silsesquioxane resin (HSiO₃/₂)ₙ prepared according to U.S. Patent No. 3,615,272 in methyl isobutyl ketone to a pre-cured thickness of 5200 Å on a SEMIX 6132U spin coater followed by sequential bakes on three open ended nitrogen purged hot plates at 150, 200 and 350°C. for one minute each. The wafers were then heated in a quartz tube furnace heated to the given temperature under a nitrogen atmosphere containing the given amount of oxygen. Results are given in Table 1. These results demonstrate that when there is less than 100 ppm of oxygen in the furnace during cure, the dielectric constant of the ceramic-like coating is significantly reduced (e.g. see runs 5 and 9). Runs 1-4 and 8-16 are not within the scope of these claims however, they were used to generate Fig. 1.

**Table 1:**

| Conditions and Results of Box-Benken Designed Experiment | | | | | | |
|---|---|---|---|---|---|---|
| Run No. | Soak Temp (°C) | Soak Time (hr) | Amt. O₂ (ppm) | Thickness After Cure (Å) | Dielectric Constant | % SiH Remaining After Cure |
| 1 | 350 | 0.5 | 100 | 5259 | 2.75 | 89 |
| 2 | 350 | 1 | 10 | 5033 | 2.78 | 89 |
| 3 | 350 | 1 | 1000 | 5192 | 2.87 | 87 |
| 4 | 350 | 1.5 | 100 | 5243 | 2.92 | 87 |
| 5 | 400 | 1.5 | 10 | 5127 | 2.99 | 76 |
| 6 | 400 | 0.5 | 10 | 5189 | 3.03 | 80 |
| 7 | 450 | 1 | 10 | 4991 | 3.42 | 56 |
| 8 | 400 | 0.5 | 1000 | 4869 | 3.44 | 46 |
| 9 | 400 | 1.5 | 1000 | 4899 | 3.99 | 41 |
| 10 | 400 | 1 | 100 | 4878 | 4.00 | 43 |
| 11 | 400 | 1 | 100 | 4807 | 4.09 | 39 |
| 12 | 400 | 1 | 100 | 4746 | 4.22 | 41 |
| 13 | 400 | 1 | 100 | 4813 | 4.26 | 41 |
| 14 | 450 | 1 | 1000 | 4562 | 4.36 | 24 |
| 15 | 450 | 0.5 | 100 | 4664 | 4.46 | 29 |
| 16 | 450 | 1.5 | 100 | 4663 | 4.80 | 24 |

## Claims

1. A method of forming a coating on a substrate wherein said method comprises
(A) coating the substrate with a coating composition comprising a hydrogen silsesquioxane resin to form a preceramic coating on the substrate;
(B) heating the preceramic coating to a temperature of at least 375°C. in an inert atmosphere containing less than 100 ppm of oxygen for a period of time sufficient to convert the preceramic coating to a ceramic-like coating.

2. The method as claimed in claim 1 wherein the coating composition additionally comprises a solvent and the solvent is evaporated to form the preceramic coating on the substrate.

3. The method as claimed in claim 1 or claim 2 wherein the hydrogen silsesquioxane resin is a resin having the units of the formula HSi(OH)ₓ(OR)_{y}O_{z/2}, in which each R is independently an organic group or a substituted organic group which, when bonded to silicon through the oxygen atom, forms a hydrolyzable substituent, x = 0 to 2, y = 0 to 2, z = 1 to 3, x + y + z = 3.

4. The method as claimed in claim 1 or claim 2 wherein the hydrogen silsesquioxane resin is a resin having the formula (HSiO_{3/2})ₙ wherein n is an integer having a value of at least 8.

5. The method as claimed in any of claims 1 to 4 wherein the coating composition further comprises a catalyst containing an element selected from platinum, rhodium and copper.

6. The method as claimed in any of claims 1 to 4 wherein the coating composition further contains ceramic oxide precursor comprising a compound containing an element selected from the group consisting of aluminum, titanium, zirconium, tantalum, niobium, vanadium boron and phosphorous wherein the compound contains at least one hydrolyzable substituent selected from the group consisting of alkoxy and acyloxy and the compound is present in an amount such that the coating composition contains from 0.1 to 30 wt% of the ceramic oxide precursor based on the weight of hydrogen silsesquioxane resin.

7. The method as claimed in any of claims 1 to 6 wherein the substrate is an electronic substrate.

8. The method as claimed in any of claims 1 to 7 wherein the inert atmosphere contains no more than 10 ppm of oxygen.

9. The method as claimed in any of claims 1 to 8 wherein the preceramic coating is heated at a temperature in the range of 400 to 450°C.

10. The method as claimed in any of claims 1 to 9 wherein the method additionally comprises applying over the ceramic-like coating a coating selected from the group consisting of SiO₂ coatings, SiO₂/ceramic oxide layers, silicon containing coatings, silicon carbon containing coatings, silicon nitrogen containing coatings, silicon oxygen nitrogen containing coatings, silicon nitrogen carbon containing coatings and diamond like coatings.

## Patentansprüche

1. Verfahren zur Ausbildung einer Beschichtung auf einem Substrat, wobei dieses Verfahren umfaßt:
(A) Beschichten des Substrats mit einer Beschichtungszusammensetzung, die ein Wasserstoffsilsesquioxanharz enthält, um eine präkeramische Beschichtung auf dem Substrat auszubilden,
(B) Erhitzen der präkeramischen Beschichtung auf eine Temperatur von wenigstens 375°C in einer Inertatmosphäre, die weniger als 100 ppm Sauerstoff enthält, für einen Zeitraum, der ausreicht, um die präkeramische Beschichtung in eine keramikartige Beschichtung umzuwandeln.

2. Verfahren wie in Anspruch 1 beansprucht, wobei die Beschichtungszusammensetzung zusätzlich ein Lösungsmittel enthält und das Lösungsmittel verdampft wird, um die präkeramische Beschichtung auf dem Substrat auszubilden.

3. Verfahren wie in Anspruch 1 oder 2 beansprucht, wobei das Wasserstoffsilsesquioxanharz ein Harz mit den Einheiten der Formel HSi(OH)ₓ(OR)_{y}O_{z/2} ist, worin jedes R unabhängig eine organische Gruppe oder eine substituierte organische Gruppe ist, die, wenn sie an Silicium über ein Sauerstoffatom gebunden ist, einen hydrolysierbaren Substituenten bildet, x = 0 bis 2 ist, y = 0 bis 2 ist, z = 1 bis 3 ist, x+y+z = 3 ist.

4. Verfahren wie in Anspruch 1 oder 2 beansprucht, wobei das Wasserstoffsilsesquioxanharz ein Harz mit der Formel (HSiO_{3/2})ₙ ist, worin n eine ganze Zahl mit einem Wert von wenigstens 8 ist.

5. Verfahren wie in einem der Ansprüche 1 bis 4 beansprucht, wobei die Beschichtungszusammensetzung weiterhin einen Katalysator enthält, der ein Element ausgewählt aus Platin, Rhodium und Kupfer enthält.

6. Verfahren wie in einem der Ansprüche 1 bis 4 beansprucht, wobei die Beschichtungszusammensetzung weiterhin einen Vorläufer eines keramischen Oxids enthält, der eine Verbindung umfaßt, die ein Element ausgewählt aus der Gruppe bestehend aus Aluminium, Titan, Zirkon, Tantal, Niob, Vanadin, Bor und Phosphor enthält, wobei die Verbindung wenigstens einen hydrolysierbaren Substituenten enthält, der ausgewählt ist aus der Gruppe bestehend aus Alkoxy und Acyloxy, und die Verbindung in einer Menge vorhanden ist, so daß die Beschichtungszusammensetzung von 0,1 bis 30 Gew.-% des Vorläufers eines keramischen Oxids, bezogen auf das Gewicht des Wasserstoffsilsesquioxanharzes, enthält.

7. Verfahren wie in einem der Ansprüche 1 bis 6 beansprucht, wobei das Substrat ein elektronisches Substrat ist.

8. Verfahren wie in einem der Ansprüche 1 bis 7 beansprucht, wobei die Inertatmosphäre nicht mehr als 10 ppm Sauerstoff enthält.

9. Verfahren wie in einem der Ansprüche 1 bis 8 beansprucht, wobei die vorkeramische Beschichtung auf eine Temperatur im Bereich von 400 bis 450°C erhitzt wird.

10. Verfahren wie in einem der Ansprüche 1 bis 9 beansprucht, wobei das Verfahren zusätzlich umfaßt: Aufbringen einer Beschichtung ausgewählt aus der Gruppe bestehend aus SiO₂-Beschichtungen, SiO₂/keramischen Oxidschichten, siliciumhaltigen Beschichtungen, silicium-kohlenstoffhaltigen Beschichtungen, silicium-stickstoffhaltigen Beschichtungen, silicium-sauerstoff-stickstoffhaltigen Beschichtungen, silicium-stickstoff-kohlenstoffhaltigen Beschichtungen und diamantähnlichen Beschichtungen, auf die keramikartige Beschichtung.

## Revendications

1. Procédé de formation d'un revêtement sur un substrat, ledit procédé comprenant
(A) le revêtement du substrat avec une composition de revêtement comprenant une résine d'hydrogénosilsesquioxane pour former un revêtement précéramique sur le substrat ;
(B) le chauffage du revêtement précéramique à une température d'au moins 375 °C dans une atmosphère inerte contenant moins de 100 ppm d'oxygène pendant une période de temps suffisante pour convertir le revêtement précéramique en un revêtement semblable à une céramique.

2. Procédé selon la revendication 1, dans lequel la composition de revêtement comprend en plus un solvant et le solvant est évaporé pour former le revêtement précéramique sur le substrat.

3. Procédé selon la revendication 1 ou la revendication 2, dans lequel la résine d'hydrogénosilsesquioxane est une résine ayant des motifs de formule HSi(OH)ₓ(OR)_{y}O_{z/2}, dans lesquels chaque R est indépendamment un groupe organique ou un groupe organique substitué qui, lorsqu'il est lié au silicium par l'atome d'oxygène, forme un substituant hydrolysable, x=0 à 2, y=0 à 2, z=1 à 3, x+y+z=3.

4. Procédé selon la revendication 1 ou la revendication 2, dans lequel la résine d'hydrogénosilsesquioxane est une résine ayant la formule (HSiO_{3/2})ₙ dans laquelle n est un entier ayant une valeur d'au moins 8.

5. Procédé selon l'une quelconque des revendications 1 à 4, dans lequel la composition de revêtement comprend en outre un catalyseur contenant un élément choisi parmi le platine, le rhodium et le cuivre.

6. Procédé selon l'une quelconque des revendications 1 à 4, dans lequel la composition de revêtement contient en outre un précurseur d'oxyde céramique comprenant un composé contenant un élément choisi dans le groupe constitué par l'aluminium, le titane, le zirconium, le tantale, le niobium, le vanadium, le bore et le phosphore, dans lequel le composé contient au moins un substituant hydrolysable choisi dans le groupe constitué par les groupes alcoxy et acyloxy et le composé est présent en une proportion telle que la composition de revêtement contient de 0,1 à 30 % en poids du précurseur d'oxyde céramique sur la base du poids de la résine d'hydrogénosilsesquioxane.

7. Procédé selon l'une quelconque des revendications 1 à 6, dans lequel le substrat est un substrat électronique.

8. Procédé selon l'une quelconque des revendications 1 à 7, dans lequel l'atmosphère inerte ne contient pas plus de 10 ppm d'oxygène.

9. Procédé selon l'une quelconque des revendications 1 à 8, dans lequel le revêtement précéramique est chauffé à une température dans la gamme de 400 à 450 °C.

10. Procédé selon l'une quelconque des revendications 1 à 9, le procédé comprenant de plus l'application, sur le revêtement semblable à une céramique, d'un revêtement choisi dans le groupe constitué par les revêtement de SiO₂, les couches de SiO₂/oxyde céramique, les revêtements contenant du silicium, les revêtements contenant du silicium et du carbone, les revêtements contenant du silicium et de l'azote, les revêtements contenant du silicium, de l'oxygène et de l'azote, les revêtements contenant du silicium, de l'azote et du carbone, et les revêtements semblables au diamant.
